# EUROPÄISCHE PATENTSCHRIFT

(11) **EP 4 012 428 B1**
(45) Veröffentlichungstag und Bekanntmachung des Hinweises auf die Patenterteilung: **07.06.2023**
(21) Anmeldenummer: 21204365.7
(22) Anmeldetag: 25.10.2021
(51) Int. Cl.: G01R 31/364, G01R 1/20

(54) **WIDERSTANDSELEMENT UND VERFAHREN ZUR HERSTELLUNG EINES WIDERSTANDSELEMENTS**
RESISTOR ELEMENT AND METHOD FOR PRODUCING A RESISTOR ELEMENT
ÉLÉMENT DE RÉSISTANCE ET PROCÉDÉ DE FABRICATION D'UN ÉLÉMENT DE RÉSISTANCE

(30) Priorität: 09.12.2020 DE 102020215555
(43) Veröffentlichungstag der Anmeldung: 15.06.2022
(73) Patentinhaber: Continental Automotive Technologies GmbH, 30165 Hannover (DE)
(72) Erfinder: Frenzel, Henryk, 60488 Frankfurt am Main (DE); Schramme, Martin, 60488 Frankfurt am Main (DE); Aumer, Andreas, 60488 Frankfurt am Main (DE)
(74) Vertreter: Continental Corporation

(56) Entgegenhaltungen:
- EP-A2- 0 391 751
- JP-A- 2011 053 095
- US-A1- 2010 237 982
- US-A1- 2017 089 955
- US-B2- 7 170 295

## Beschreibung

Die Erfindung betrifft ein Widerstandselement für einen Batteriesensor, mit einem ersten Anschlusselement und einem zweiten Anschlusselement sowie einem ersten Messwiderstand und einem zweiten Messwiderstand, wobei der erste Messwiderstand und der zweite Messwiderstand elektrisch in Reihe zwischen dem ersten Anschlusselement und dem zweiten Anschlusselement angeordnet. Die Erfindung betrifft des Weiteren ein Herstellungsverfahren für eine solche Widerstandsbaugruppe.

Batteriesensoren werden in Fahrzeugen eingesetzt, um Informationen über den Batteriezustand, beispielsweise den Ladezustand der Batterie, zu erhalten. Die zu erfassenden Batterieparameter sind beispielsweise die Batteriespannung, der Batteriestrom und die Temperatur der Batterie, wobei insbesondere die Batteriespannung und der Batteriestrom permanent erfasst werden müssen, um beispielsweise eine exakte Aussage über den Zustand der Batterie, beispielsweise den Ladezustand, treffen zu können.

Die Stromerfassung erfolgt beispielsweise durch die Erfassung eines Spannungsabfalls über einen im Laststrompfad angeordneten Messwiderstandes. Der Messwiderstand ist Teil eines Widerstandselements, das jeweils ein Anschlusselement zum Verbinden des Messwiderstandes mit einem Kabelanschluss und einer Batteriepolklemme aufweist. Der elektrische Widerstand des Messwiderstandes ist sehr genau bekannt. Durch den erfassten Spannungsabfall kann über das ohmsche Gesetz der über den Messwiderstand fließende Strom, also der Laststrom, sehr genau ermittelt werden.

In der US 7 170 295 B2 und der JP 2011 053 095 A ist jeweils ein Widerstandselement mit mehreren Strommesspfaden gezeigt, wobei jeder dieser Strommesspfade einen separaten Messwiderstand aufweist.

In der US2010/237982 A1 ist ein Widerstandselement mit mehreren, in einer Reihenschaltung angeordneten Messwiderständen gezeigt.

Für die Messwiderstände werden üblicherweise spezielle Legierungen verwendet, beispielsweise eine Kupfer-Nickel-Mangan-Legierung, die einen geringeren Widerstands-Temperaturkoeffizienten, also eine geringe Empfindlichkeit bei Temperaturänderungen, aufweisen, so dass der elektrische Wiederstand sehr genau bestimmt werden kann und/oder geringen Änderungen unterliegt.

Die Anschlussabschnitte bestehen üblicherweise aus einer Kupferlegierung mit einem geringen elektrischen Widerstand und sind mit dem Messwiderstand verschweißt.

Die verwendeten Kupferlegierungen für die Leitungsabschnitte haben eine höhere Temperaturabhängigkeit des elektrischen Widerstandes, also einen hohen Widerstands-Tem peraturkoeffizient.

Die Messkontakte sind üblicherweise auf den Leitungsabschnitten angeordnet, sodass sich der elektrische Gesamtwiderstand aus dem elektrischen Widerstand des Messwiderstandes sowie den elektrischen Widerständen der Leitungsabschnitte zwischen den Messkontakten zusammensetzt.

Aufgrund der höheren Temperaturabhängigkeit des elektrischen Widerstandes der Leitungsabschnitte beeinflussen diese den elektrischen Gesamtwiderstand und somit die Genauigkeit der Messung.

Das Verhalten des elektrischen Widerstandes des Messwiderstandes und der Leitungsabschnitte bei verschiedenen Temperaturen ist bekannt, sodass bei bekannter Temperatur der genaue elektrische Widerstand bestimmt werden kann. Zur Bestimmung der Temperatur ist aber ein zusätzlicher Temperatursensor erforderlich.

Insgesamt ist aber eine geringe Temperaturabhängigkeit des elektrischen Gesamtwiderstandes erwünscht, um eine möglichst genaue Messung zu ermöglichen.

Des Weiteren sind aus dem Stand der Technik Widerstandselemente bekannt, die mehrere Messwiderstände aufweisen. Der Batteriesensor ist so ausgebildet, dass die an den Messwiderständen abfallenden Spannungen einzeln oder gemeinsam erfasst werden können. Durch die verschiedenen Messwerte ist beispielsweise eine genauere Messung des Stroms und/oder einer Kalibrierung der elektrischen Widerstände der einzelnen Messwiderstände möglich.

Der Aufbau und die Herstellung eines solchen Widerstandselements mit mehreren Messwiderständen sind aber sehr aufwendig. Zudem benötigen diese Widerstandselemente häufig sehr viel Bauraum.

Aufgabe der Erfindung ist es, ein Widerstandselement mit zumindest zwei in Reihe angeordneten Messwiderständen bereitzustellen, das einfach herzustellen ist und einen möglichst geringen Bauraum benötigt. Des Weiteren soll das Widerstandselement eine höhere Messgenauigkeit, insbesondere eine geringere Temperaturabhängigkeit des elektrischen Widerstandes, aufweisen.

Zur Lösung der Aufgabe ist ein Widerstandselement für einen Batteriesensor gemäß Anspruch 1 vorgesehen.

Die Messwiderstände sind also nicht auf einer gemeinsamen Geraden angeordnet, sondern gewissermaßen nebeneinander angeordnet. Das Widerstandselement ist dadurch zumindest im Bereich der Messwiderstände U-förmige oder wellenförmig ausgebildet. Dadurch ergibt sich durch das Widerstandselement kein geradliniger Stromfluss. Insbesondere verläuft die Hauptstromrichtung durch die Messwiderstände und die unmittelbar angrenzenden Bereiche der Anschlusselemente bzw. des Zwischenelements nicht auf der Mittelachse des jeweiligen Bauteils. Dies führt zu einem geänderten Stromfluss bzw. zu geänderten Potentiallinien innerhalb des Messwiderstandes und der angrenzenden Bereiche der Leitungsabschnitt. Durch eine Positionierung der Messkontakte kann in Verbindung mit dem durch die Geometrie des Widerstandselements veränderten Stromfluss bzw. den geänderten Potentiallinien die Temperaturabhängigkeit des elektrischen Widerstandes zwischen den Messkontakten positiv beeinflusst werden, insbesondere reduziert werden, da der temperaturbedingte Einfluss der Leitungsabschnitte geringer ausfällt. Grundsätzlich sind die Messkontakte so angeordnet, dass diese außerhalb der Hauptstromrichtung liegen. Insbesondere können die Messkontakte quer zur Längsrichtung des Messwiderstandes so angeordnet sein, dass der Einfluss einer temperaturbedingten Änderung des elektrischen Widerstandes des Messwiderstandes und/oder der Leitungsabschnitte reduziert und/oder kompensiert ist. Um die Spannungsabfälle der einzelnen Messwiderstände erfassen zu können, ist auf dem Zwischenelement jeweils ein einem Messwiderstand zugeordnete zweiter Messkontakte vorgesehen. Der zweite Messkontakte ist jeweils in einem dem anderen Messwiderstand abgewandten Abschnitt des Leitungselements vorgesehen, sodass sich dieser ebenfalls außerhalb des Hauptstromflusses befindet.

Grundsätzlich sind die beiden Messwiderstände so angeordnet und mit einem der Anschlusselemente bzw. dem Zwischenelement verbunden, dass sich in den Messwiderständen und den unmittelbar angrenzenden Bereichen der Anschlusselement und des Zwischenelements eine Hauptstromrichtung einstellt, die von der geometrischen Längsrichtung der Messwiderstände, der Anschlusselemente und des Zwischenelements abweicht. Die Messkontakte sind hierbei so angeordnet, dass sich diese nicht in der Hauptstromrichtung befinden, sondern seitlich versetzt.

Vorzugsweise verlaufen der erste Rand und der zweite Rand des ersten Messwiderstandes und/oder der erste Rand und der zweite Rand des zweiten Messwiderstandes parallel zueinander, sodass die ersten Ränder und die zweiten Ränder der Messwiderstände jeweils auf einer gemeinsamen Geraden verlaufen. Die Messwiderstände sind in dieser Ausführungsform parallelogrammartig oder trapezartig ausgebildet. Ein solches Widerstandselement ist besonders einfach herzustellen. Üblicherweise wird das Widerstandselement aus einem flächigen Grundmaterial hergestellt. Das flächige Grundmaterial besteht aus einem ersten Abschnitt, einem zweiten Abschnitt und einem länglichen Widerstandsabschnitt, wobei der erste Abschnitt und der zweite Abschnitt aus einem elektrisch leitenden Material bestehen und der längliche Widerstandsabschnitt mit zwei gegenüberliegende Rändern jeweils elektrisch leitend mit einem der Abschnitte verbunden ist. Das Grundmaterial wird beispielsweise auf Rollen als Endlosmaterial angeliefert. Die Ränder des Widerstandsabschnitts verlaufen parallel zueinander, sodass parallelogrammartige oder trapezartige Messwiderstände auf einfache Weise aus dem Grundmaterial ausgeschnitten werden können. Die Anschlusselemente werden hierbei aus einem der beiden Abschnitte ausgeschnitten, das Zwischenelement aus dem anderen Abschnitt. Da das Grundmaterial nur einen Widerstandsabschnitt aufweist, um ein Widerstandselement mit zwei Messwiderständen herzustellen, ist zudem eine einfachere und kostengünstigere Herstellung möglich.

Die freien Ränder des ersten Messwiderstandes, die den ersten Rand und den zweiten Rand des ersten Messwiderstandes verbinden, und/oder die freien Ränder des zweiten Messwiderstandes, die den ersten Rand und den zweiten Rand des zweiten Messwiderstandes verbinden, können beispielsweise parallel zueinander verlaufen, sodass die Messwiderstände parallelogrammartig oder rechteckig ausgebildet sind.

Die ersten Ränder und/oder die zweiten Ränder können unterschiedlich lang ausgebildet sein, sodass die Messwiderstände unterschiedlich breit ausgebildet sind, wodurch diese verschiedene elektrische Widerstände aufweisen. Die Verwendung von zwei verschiedenen elektrischen Widerständen kann bei der Messung Vorteile haben, da verschiedene Spannungsabfälle gemessen werden können.

Alternativ können die ersten Ränder und/oder die zweiten Ränder auch gleich lang ausgebildet sein, sodass die elektrischen Widerstände der beiden Messwiderstände gleich groß sind.

Die Längsrichtung des ersten Anschlusselement und/oder die Längsrichtung des zweiten Anschlusselements schließt vorzugsweise mit dem ersten Rand des jeweils verbundenen Messwiderstandes einen Winkel von weniger als 90°, insbesondere von 0°, ein.

Die Anschlusselemente können beispielsweise in Verlängerung des jeweils mit diesem verbundenen Messwiderstandes angeordnet sein. Vorzugsweise sind die Anschlusselemente aber so angeordnet, dass sich durch diese die Hauptstromrichtung innerhalb des Messwiderstandes und der unmittelbar angrenzenden Bereiche des Anschlusselement verändert. Vorzugsweise verläuft die Längsrichtung der Anschlusselemente rechtwinklig, sodass sich eine starke Änderung der Stromrichtung ergibt.

Das Zwischenelement erstreckt sich vorzugsweise im Wesentlichen in Richtung der zweiten Ränder, so dass auch zwischen den Messwiderstand in eine Änderung der Hauptstromrichtung erfolgt.

Auf dem Zwischenelement kann ein dritter Messkontakte vorgesehen sein, der der geometrisch zwischen dem ersten Messwiderstand und dem zweiten Messwiderstand angeordnet ist. Dieser dritte Messkontakte befindet sich im Hauptstromfluss und kann alternativ oder ergänzend zu den zweiten Messkontakten vorgesehen sein.

Zur Lösung der Aufgabe ist des Weiteren ein Verfahren zur Herstellung eines vorstehend beschriebenen Widerstandselements für einen Batteriesensor gemäß Anspruch 9 vorgesehen.

"Ausschneiden" bezeichnet hier bei jegliches Trennverfahren, mit dem die Anschlusselemente, die Messwiderstände und das Zwischenelement aus dem Grundmaterial herausgelöst werden können, beispielsweise Laserschneiden oder Stanzen.

Weitere Vorteile und Merkmale ergeben sich aus der nachfolgenden Beschreibung in Verbindung mit den beigefügten Zeichnungen. In diesen zeigen:
- Figur 1: eine erste Ausführungsform eines erfindungsgemäßen Widerstandselements;
- Figur 2: eine schematische Darstellung des Stromflusses im Widerstandselement aus Figur 1;
- Figur 3: eine zweite Ausführungsform eines erfindungsgemäßen Widerstandselements;
- Figur 4: eine dritte Ausführungsform eines erfindungsgemäßen Widerstandselements; und
- Figur 5: einen Herstellungsschritt zur Herstellung des Widerstandselements aus Figur 1.

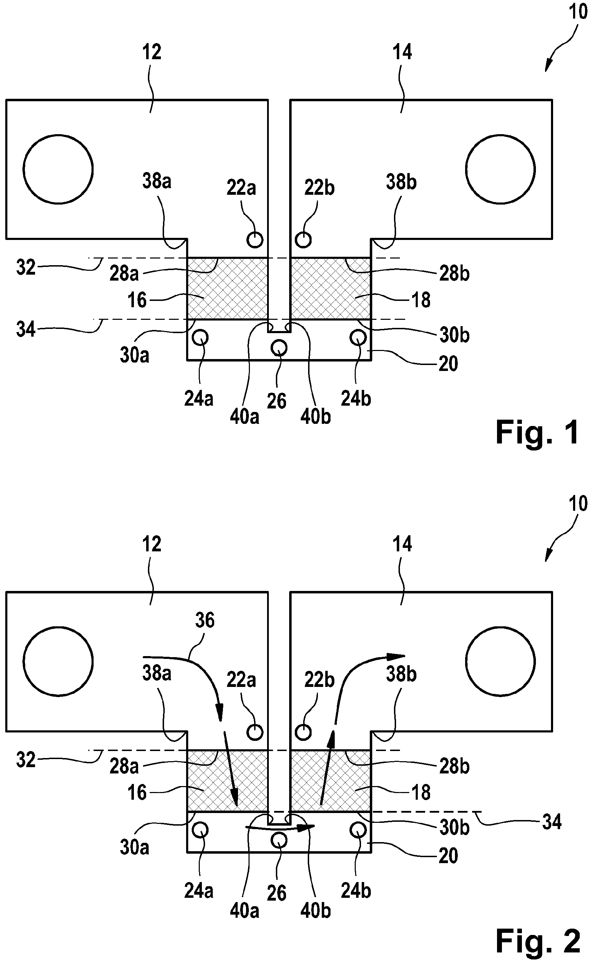

In Figur 1 ist ein Widerstandselement 10 für einen Batteriesensor gezeigt. Das Widerstandselement 10 hat ein erstes Anschlusselement 12 sowie ein zweites Anschlusselement 14, um das Widerstandselement 10 mit einer Batteriepolklemme und einem Kabel zu verbinden. Das Widerstandselement 10 weist des Weiteren einen ersten Messwiderstand 16 und einen zweiten Messwiderstand 18 auf, die in Reihe zwischen dem ersten Anschlusselement 12 und dem zweiten Anschlusselement 14 angeordnet sind. Zwischen dem ersten Messwiderstand 16 und dem zweiten Messwiderstand 18 ist ein Zwischenelement 20 vorgesehen.

Auf den Anschlusselementen 12, 14 ist jeweils ein erster Messkontakte 22a, 22b vorgesehen. Auf dem Zwischenelement 20 sind zwei zweite Messkontakte 24a, 24b vorgesehen, die jeweils einem der beiden Messwiderstände 16, 18 zugeordnet sind. Des Weiteren ist ein dritter Messkontakte 26 vorgesehen, der zwischen den beiden zweiten Messkontakten 24a, 24b angeordnet ist.

Über die Messkontakte 22a, 24a bzw.22b, 24b kann jeweils ein Spannungsabfall über dem Messwiderstand 16 bzw. 18 gemessen werden. Aus diesem Spannungsabfall kann mit dem bekannten oder ermittelten elektrischen Widerstand des Messwiderstandes 16 bzw. 18 über das ohmsche Gesetz der über den Messwiderstand 16 bzw. 18 fließende Strom bestimmt werden.

Die Anschlusselemente 12, 14 sowie das Zwischenelement 20 sind aus einem elektrisch leitenden Material, beispielsweise aus Kupfer oder einer Kupferlegierung. Die Messwiderstände 16, 18 sind aus einem Material mit einer geringen Temperaturabhängigkeit des elektrischen Widerstandes, beispielsweise einer Kupfer-Nickel-Mangan-Legierung.

Der erste Messwiderstand 16 ist mit einem ersten Rand 28a mit dem ersten Anschlusselement 12 und mit einem zweiten Rand 30a mit dem Zwischenelement 20 verbunden. Der zweite Messwiderstand 18 ist mit einem ersten Rand 28b mit dem zweiten Anschlusselement 14 und mit einem zweiten Rand 30b mit dem Zwischenelement 20 verbunden.

Wie in Figur 1 zu sehen ist, sind der erste Rand 28a des ersten Messwiderstandes 16 und der erste Rand 28b des zweiten Messwiderstandes 16 auf einer gemeinsamen Geraden 32 angeordnet. Des Weiteren sind die zweiten Ränder 30a, 30b der Messwiderstände 16, 18 ebenfalls auf einer gemeinsamen Geraden 34 angeordnet.

Die beiden Messwiderstände 16, 18 sind somit elektrisch in Reihe geschaltet, befinden sich aber geometrisch gesehen nebeneinander und bilden gemeinsam mit dem Zwischenelement einen U-förmigen Leitungsabschnitt.

Die Anschlusselemente 12, 14 bzw. das Zwischenelement 20 haben einen anderen elektrischen Widerstand als die Messwiderstände 16, 18. Insbesondere ist die Temperaturabhängigkeit der elektrischen Widerstände der Anschlusselemente 12, 14 bzw. des Zwischenelements 20 größer als die Temperaturabhängigkeit des elektrischen Widerstandes der Messwiderstände 16, 18.

Fließt durch das Widerstandselement 10 Strom, wird dieser sich üblicherweise den Weg des geringsten elektrischen Widerstandes suchen. Die Längsrichtung der Anschlusselemente 12, 14 verläuft im Wesentlichen rechtwinklig zur Längsrichtung der Messwiderstände 16, 18 verläuft und auch die Längsrichtung des Zwischenelements 20 verläuft im Wesentlichen rechtwinklig zur Längsrichtung der Messwiderstandes 16, 18. Dadurch erfährt auch der vom ersten Anschlusselement 12 zum zweiten Anschlusselement 14 fließende Strom entsprechende Richtung Änderungen, wobei die Hauptstromrichtung 36 zumindest abschnittsweise nicht der Längsrichtung der Messwiderstände 16, 18 bzw. der Anschlusselemente 12, 14 und des Zwischenelements 20 entspricht.

Insbesondere verläuft die Hauptstromrichtung 36 im Bereich der Innenecken 38a, 38b, 40a, 40b zwischen den Anschlusselement und 12, 14 und den Messwiderständen 16, 18 bzw. zwischen den Messwiderständen 16, 18 und dem Zwischenelement 20.

Wie in Figur 2 zu sehen ist, sind die ersten Messkontakte 22a, 22b auf den diesen Innenecken 38a, 38b abgewandten Bereichen der Anschlusselement 12, 14 angeordnet. Des Weiteren sind auch die zweiten Messkontakte 24a, 24b auf den den Innenecken 40a, 40b abgewandten Bereichen des Zwischenelements 20 angeordnet. Die Messkontakte 22a, 22b, 24a, 24b sind somit außerhalb der Hauptstromrichtung 36 angeordnet. Die direkte Verbindung zwischen den ersten Messpunkten 22a, 22b und den jeweils zugeordneten zweiten Messpunkten 24a, 24b entspricht also nicht der Hauptstromrichtung 36 bzw. verläuft in einem Winkel zu dieser.

Aufgrund von Temperaturänderungen kann es zu Veränderungen der elektrischen Widerstände der Anschlusselemente 12, 14, Zwischenelements 20 und der Messwiderstände 16, 18 kommen. Da die Anschlusselemente 12, 14 und das Zwischenelement 20 eine größere Temperaturabhängigkeit des elektrischen Widerstandes aufweisen, wirkt sich eine Temperaturänderung auf die elektrischen Widerstände dieser Elemente 12, 14, 20 stärker aus. Eine Temperaturänderung kann somit zu einer Veränderung des elektrischen Widerstandes innerhalb des Widerstandselements 10 führen, die zu einer Veränderung der Hauptstromrichtung 36 führen kann.

Die Messkontakte 22a, 24a bzw.22b, 24b sind jeweils so angeordnet, dass sich temperaturbedingte Änderungen des elektrischen Widerstandes der Anschlusselemente 12, 14 bzw. des Zwischenelements 20 und eine Anpassung des Hauptstrompfades 36 aufgrund der temperaturbedingten Änderung der elektrischen Widerstände zumindest teilweise, insbesondere vollständig ausgleichen, sodass temperaturbedingte Änderungen der elektrischen Widerstände der Anschlusselemente 12, 14 bzw. des Zwischenelements 20 kompliziert werden können.

Der dritte Messkontakt 26 kann anstelle der zweiten Messkontakte 24a, 24b verwendet werden, so dass auf dem Zwischenelement 20 nur ein Messkontakt 26 erforderlich ist. Der dritte Messkontakt kann aber auch als zusätzlicher Kontakt im Hauptstrompfad 36 verwendet werden, wobei beispielsweise ein Vergleich zwischen den gemessenen Spannungsabfällen zwischen dem ersten Messkontakt 22a und dem zweiten Messkontakt 24a sowie zwischen dem ersten Messkontakt 22a und dem dritten Messkontakt 26 erfolgen kann.

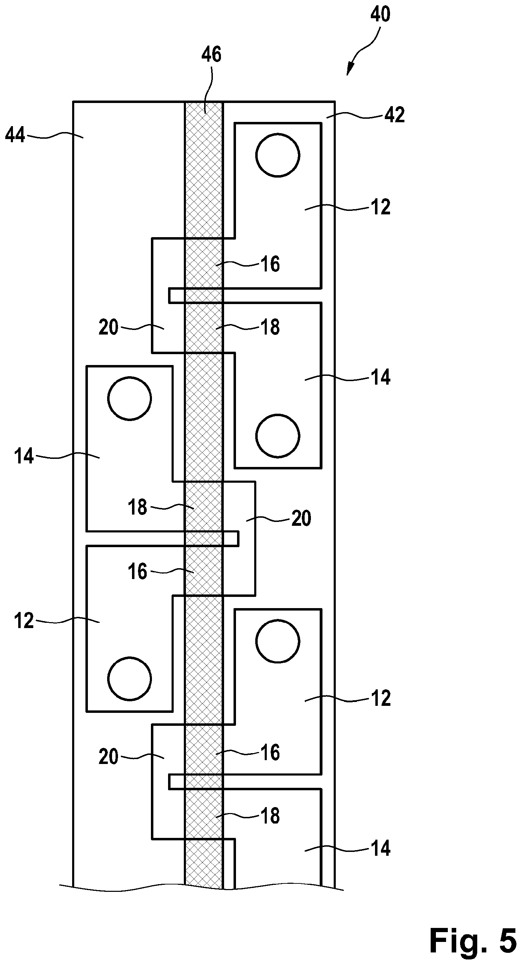

Das Figur 1 gezeigte Widerstandselement 10 kann auf einfache Weise aus einem in Figur 5 dargestellten Grundmaterial 40 hergestellt werden.

Das Grundmaterial 40 besteht aus einem ersten Abschnitt 42, einem zweiten Abschnitt 44 und einem länglichen Widerstandsabschnitt 46. Der erste Abschnitt 42 und der zweite Abschnitt bestehen aus einem elektrisch leitenden Material, beispielsweise Kupfer oder einer Kupferlegierung. Der längliche Widerstandsabschnitt 46 besteht aus einem Widerstandsmaterial, beispielsweise aus einer Kupfer-Nickel-Mangan-Legierung. Der Widerstandsabschnitt 46 weist zwei gegenüberliegende Rändern 48, 50 auf, wobei der erste Abschnitt 42 und der zweite Abschnitt 44 jeweils elektrisch leitend mit einem der Ränder 48, 50 des Widerstandsabschnitts 46 verbunden sind.

Das Widerstandselements 10 wird aus diesem Grundmaterial 40 ausgeschnitten, wobei das ersten Anschlusselement 12 und das zweite Anschlusselement 14 aus dem ersten Abschnitt 42 ausgeschnitten werden, der erste Messwiderstand 16 und der zweite Messwiderstand 18 aus dem Widerstandsabschnitt 46 und das Zwischenelement 20 aus dem zweiten Abschnitt 44.

Obwohl das Grundmaterial 40 nur einen Widerstandsabschnitt 46 aufweist können durch die Form des Widerstandselements 10 zwei in Reihe angeordnete Messwiderstände 16, 18 aus diesem Grundmaterial 40 hergestellt werden.

Dieses Herstellungsverfahren bietet des Weiteren den Vorteil, dass die Form der Messwiderstände 16, 18, der Anschlusselemente 12, 14 sowie des Zwischenelements 20 beliebig gewählt werden kann. Insbesondere können für die Messwiderstände 16,18 verschiedene Formen vorgesehen sein.

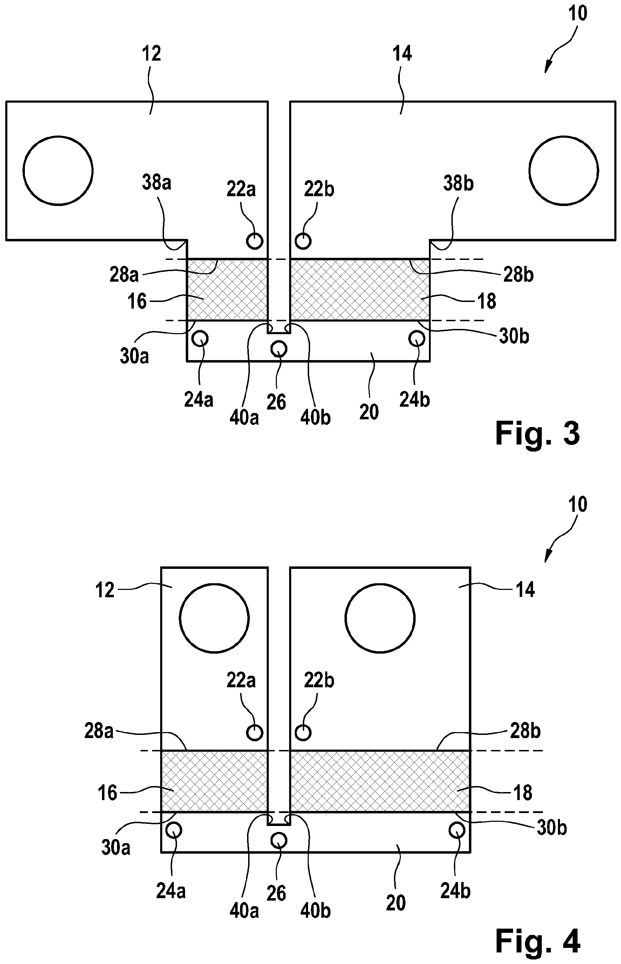

Beispielsweise können die Messwiderstände 16, 18 verschiedene Breiten vorgesehen sein, sodass diese verschiedene elektrische Widerstände aufweisen (siehe Figur 3).

In den bisher gezeigten Ausführungsformen weisen die Messwiderstände 16, 18 rechteckige Formen auf. Es ist aber auch möglich, dass die freien Ränder der Messwiderstände 16, 18 nicht parallel zueinander und/oder nicht senkrecht zu den Rändern 22a, 22b, 24a, 24b verlaufen. Insbesondere können die Messwiderstände 16, 18 auch parallelogrammartig oder trapezartig ausgebildet sein.

Des Weiteren können auch die Anschlusselemente 12, 14 beliebig ausgebildet sein. Insbesondere kann die Längsrichtung der Anschlusselemente 12, 14 beliebig ausgebildet sein. In der in Figur 4 gezeigten Ausführungsform sind die Anschlusselemente 12, 14 so angeordnet, dass deren Längsachse in Richtung der Längsachse der Messwiderstände 16, 18 verläuft.

Unabhängig von der Form der Messwiderstände 16, 18 sowie der Ausrichtung der Anschlusselemente 12, 14 sind die Messkontakte 22a, 22b, 24a, 24b so angeordnet, dass diese temperaturbedingte Schwankungen der elektrischen Widerstände der Anschlusselemente 12, 14 der Messwiderstände 16, 18 sowie des Zwischenelements 20 kompensieren oder vollständig ausgleichen können.

## Patentansprüche

1. Widerstandselement (10) für einen Batteriesensor, mit einem ersten Anschlusselement (12) und einem zweiten Anschlusselement (14) sowie einem ersten Messwiderstand (16) und einem zweiten Messwiderstand (18), wobei der erste Messwiderstand (16) und der zweite Messwiderstand (18) elektrisch in Reihe zwischen dem ersten Anschlusselement (12) und dem zweiten Anschlusselement (14) angeordnet sind und wobei zwischen dem ersten Messwiderstand (16) und dem zweiten Messwiderstand (18) ein elektrisch leitendes Zwischenelement (20) vorgesehen ist, wobei der erste Messwiderstand (16) mit einem ersten Rand (28a) mit dem ersten Anschlusselement (12) und der zweite Messwiderstand (18) mit einem ersten Rand (28b) mit dem zweiten Anschlusselement (14) verbunden sind, und wobei der erste Messwiderstand (16) und der zweite Messwiderstand (18) jeweils mit einem zweiten Rand (30a,30b) mit dem Zwischenelement (20) verbunden sind,
wobei der erste Rand (28a) des ersten Messwiderstandes (16) und der erste Rand (28b) des zweiten Messwiderstandes (18) und/oder der zweite Rand (30a) des ersten Messwiderstandes (16) und der zweite Rand (30b) des zweiten Messwiderstandes (18) jeweils im Wesentlichen auf einer gemeinsamen Geraden (32, 34) liegen, **dadurch gekennzeichnet, dass** am ersten Anschlusselement (12) und am zweiten Anschlusselement (14) erste Messkontakte (22a, 22b) vorgesehen sind, wobei die Messkontakte (22a, 22b) jeweils auf einem dem jeweils anderen Anschlusselement (12, 14) zugewandten Abschnitt des Anschlusselements (12, 14) vorgesehen sind, und dass auf dem Zwischenelement (20) jeweils ein einem Messwiderstand (16, 18) zugeordneter zweiter Messkontakt (24a, 24b) vorgesehen ist, wobei die zweiten Messkontakte (30a, 30b) jeweils in einem dem anderen Messwiderstand (16, 18) abgewandten Abschnitt des Zwischenelements (20) angeordnet Z sind.

2. Widerstandselement nach einem der vorhergehenden Ansprüche, **dadurch gekennzeichnet, dass** der erste Rand (28a) und der zweite Rand (30a) des ersten Messwiderstandes (16) und/oder der erste Rand (28b) und der zweite Rand (30b) des zweiten Messwiderstandes (18) parallel zueinander verlaufen.

3. Widerstandselement nach einem der vorhergehenden Ansprüche, **dadurch gekennzeichnet, dass** die freien Ränder des ersten Messwiderstandes (16), die den ersten Rand (28a) und den zweiten Rand (30a) des ersten Messwiderstandes (16) verbinden, und/oder die freien Ränder des zweiten Messwiderstandes (18), die den ersten Rand (28b) und den zweiten Rand (30a) des zweiten Messwiderstandes (18) verbinden, parallel zueinander verlaufen.

4. Widerstandselement nach einem der vorhergehenden Ansprüche, **dadurch gekennzeichnet, dass** die ersten Ränder (28a, 28b) und/oder die zweiten Ränder (30a, 30b) unterschiedlich lang ausgebildet sind.

5. Widerstandselement nach einem der Ansprüche 1 bis 3, **dadurch gekennzeichnet, dass** die ersten Ränder (28a, 28b) und/oder die zweiten Ränder (30a, 30b) gleich lang ausgebildet sind.

6. Widerstandselement nach einem der vorhergehenden Ansprüche, **dadurch gekennzeichnet, dass** die Längsrichtung des ersten Anschlusselement (12) und/oder die Längsrichtung des zweiten Anschlusselements (14) mit ersten Rand (28a, 28b) des jeweils verbundenen Messwiderstandes (16, 18) einen Winkel von weniger als 90°, insbesondere von 0°, einschließt.

7. Widerstandselement nach einem der vorhergehenden Ansprüche, **dadurch gekennzeichnet, dass** sich das Zwischenelement (20) im Wesentlichen in Richtung der zweiten Ränder (30a, 30b) erstreckt.

8. Widerstandselement nach einem der vorhergehenden Ansprüche, **dadurch gekennzeichnet, dass** auf dem Zwischenelement (20) ein dritter Messkontakt (26) vorgesehen ist, der geometrisch zwischen dem ersten Messwiderstand (16) und dem zweiten Messwiderstand (18) angeordnet ist.

9. Verfahren zur Herstellung eines Widerstandelements (10) für einen Batteriesensor, insbesondere einen Batteriesensor in einem Fahrzeug, nach einem der vorhergehenden Ansprüche, mit folgenden Schritten:
- Bereitstellen eines flächigen Grundmaterials (40) bestehend aus einem ersten Abschnitt (42), einem zweiten Abschnitt (44) und einem länglichen Widerstandsabschnitt (46), wobei der erste Abschnitt (42) und der zweite Abschnitt (44) aus einem elektrisch leitenden Material bestehen, wobei der längliche Widerstandsabschnitt (46) zwei gegenüberliegende Ränder (48, 50) aufweist, wobei der erste Abschnitt (42) und der zweite Abschnitt (44) jeweils elektrisch leitend mit einem der Ränder (48, 50) des Widerstandsabschnitts (46) verbunden sind,
- Ausschneiden des Widerstandselements (10) aus dem Grundmaterial (40), wobei das erste Anschlusselement (12) und das zweite Anschlusselement (14) aus dem ersten Abschnitt (42) ausgeschnitten werden, wobei der erste Messwiderstand (16) und der zweite Messwiderstand (18) aus dem Widerstandsabschnitt (46) ausgeschnitten werden und wobei das Zwischenelement (20) aus dem zweiten Abschnitt (44) ausgeschnitten wird.,
- am ersten Anschlusselement (12) und am zweiten Anschlusselement (14) Vorsehen von ersten Messkontakten (22a, 22b), wobei die Messkontakte (22a, 22b) jeweils auf einem dem jeweils anderen Anschlusselement (12, 14) zugewandten Abschnitt des Anschlusselements (12, 14) vorgesehen sind, und
- auf dem Zwischenelement (20) Vorsehen jeweils eines einem Messwiderstand (16, 18) zugeordneten zweiten Messkontakts (24a, 24b), wobei die zweiten Messkontakte (30a, 30b) jeweils in einem dem anderen Messwiderstand (16, 18) abgewandten Abschnitt des Zwischenelements (20) angeordnet sind.

## Claims

1. Resistance element (10) for a battery sensor, having a first terminal element (12) and a second terminal element (14) and also a first measuring resistor (16) and a second measuring resistor (18), wherein the first measuring resistor (16) and the second measuring resistor (18) are electrically arranged in series between the first terminal element (12) and the second terminal element (14), and wherein an electrically conductive intermediate element (20) is provided between the first measuring resistor (16) and the second measuring resistor (18), wherein the first measuring resistor (16) is connected by way of a first edge (28a) to the first terminal element (12) and the second measuring resistor (18) is connected by way of a first edge (28b) to the second terminal element (14), and wherein the first measuring resistor (16) and the second measuring resistor (18) are in each case connected by way of a second edge (30a, 30b) to the intermediate element (20), wherein the first edge (28a) of the first measuring resistor (16) and the first edge (28b) of the second measuring resistor (18) and/or the second edge (30a) of the first measuring resistor (16) and the second edge (30b) of the second measuring resistor (18) in each case lie substantially on a common straight line (32, 34), **characterized in that** first measurement contacts (22a, 22b) are provided on the first terminal element (12) and on the second terminal element (14), wherein the measurement contacts (22a, 22b) are in each case provided on a portion of the terminal element (12, 14) that faces towards the in each case other terminal element (12, 14), and **in that** in each case one second measurement contact (24a, 24b) assigned to a measuring resistor (16, 18) is provided on the intermediate element (20), wherein the second measurement contacts (24a, 24b) are in each case arranged in a portion of the intermediate element (20) that faces away from the other measuring resistor (16, 18).

2. Resistance element according to the preceding claim, **characterized in that** the first edge (28a) and the second edge (30a) of the first measuring resistor (16) and/or the first edge (28b) and the second edge (30b) of the second measuring resistor (18) extend parallel to one another.

3. Resistance element according to either of the preceding claims, **characterized in that** the free edges of the first measuring resistor (16), which connect the first edge (28a) and the second edge (30a) of the first measuring resistor (16), and/or the free edges of the second measuring resistor (18), which connect the first edge (28b) and the second edge (30a) of the second measuring resistor (18), extend parallel to one another.

4. Resistance element according to one of the preceding claims, **characterized in that** the first edges (28a, 28b) and/or the second edges (30a, 30b) are formed to be of different length.

5. Resistance element according to one of Claims 1 to 3, **characterized in that** the first edges (28a, 28b) and/or the second edges (30a, 30b) are formed to be of equal length.

6. Resistance element according to one of the preceding claims, **characterized in that** the longitudinal direction of the first terminal element (12) and/or the longitudinal direction of the second terminal element (14) include an angle of less than 90°, in particular of 0°, with the first edge (28a, 28b) of the in each case connected measuring resistor (16, 18).

7. Resistance element according to one of the preceding claims, **characterized in that** the intermediate element (20) extends substantially in the direction of the second edges (30a, 30b).

8. Resistance element according to one of the preceding claims, **characterized in that** a third measurement contact (26) is provided on the intermediate element (20) and is geometrically arranged between the first measurement contact (16) and the second measurement contact (18).

9. Method for producing a resistance element (10) for a battery sensor, in particular a battery sensor in a vehicle, according to one of the preceding claims, comprising the following steps:
- providing a flat base material (40) consisting of a first portion (42), a second portion (44) and an elongate resistance portion (46), wherein the first portion (42) and the second portion (44) consist of an electrically conductive material, wherein the elongate resistance portion (46) has two edges (48, 50) situated opposite one another, wherein the first portion (42) and the second portion (44) are in each case electrically conductively connected to one of the edges (48, 50) of the resistance portion (46),
- cutting the resistance element (10) out of the base material (40), wherein the first terminal element (12) and the second terminal element (14) are cut out of the first portion (42), wherein the first measuring resistor (16) and the second measuring resistor (18) are cut out of resistance portion (46), and wherein the intermediate element (20) is cut out of the second portion (44),
- providing first measurement contacts (22a, 22b) on the first terminal element (12) and on the second terminal element (14), wherein the measurement contacts (22a, 22b) are in each case provided on a portion of the terminal element (12, 14) that faces towards the in each case other terminal element (12, 14), and
- providing in each case one second measurement contact (24a, 24b) assigned to a measuring resistor (16, 18) on the intermediate element (20), wherein the second measurement contacts (30a, 30b) are in each case arranged in a portion of the intermediate element (20) that faces away from the other measuring resistor (16, 18).

## Revendications

1. Élément résistif (10) pour un capteur de batterie, avec un premier élément de raccordement (12) et un deuxième élément de raccordement (14) ainsi qu'une première résistance de mesure (16) et une deuxième résistance de mesure (18), la première résistance de mesure (16) et la deuxième résistance de mesure (18) étant agencées électriquement en série entre le premier élément de raccordement (12) et le deuxième élément de raccordement (14) et un élément intermédiaire (20) électriquement conducteur étant prévu entre la première résistance de mesure (16) et la deuxième résistance de mesure (18), la première résistance de mesure (16) étant reliée par un premier bord (28a) au premier élément de raccordement (12) et la deuxième résistance de mesure (18) étant reliée par un premier bord (28b) au deuxième élément de raccordement (14), et la première résistance de mesure (16) et la deuxième résistance de mesure (18) étant reliées respectivement par un deuxième bord (30a, 30b) à l'élément intermédiaire (20), le premier bord (28a) de la première résistance de mesure (16) et le premier bord (28b) de la deuxième résistance de mesure (18) et/ou le deuxième bord (30a) de la première résistance de mesure (16) et le deuxième bord (30b) de la deuxième résistance de mesure (18) se situant respectivement essentiellement sur une droite commune (32, 34), **caractérisé en ce que** des premiers contacts de mesure (22a, 22b) sont prévus sur le premier élément de raccordement (12) et sur le deuxième élément de raccordement (14), les contacts de mesure (22a, 22b) étant prévus respectivement sur une section de l'élément de raccordement (12, 14) tournée vers l'autre élément de raccordement respectif (12, 14),
et **en ce que** sur l'élément intermédiaire (20) est prévu respectivement un deuxième contact de mesure (24a, 24b) associé à une résistance de mesure (16, 18), les deuxièmes contacts de mesure (30a, 30b) étant agencés respectivement dans une section de l'élément intermédiaire (20) détournée de l'autre résistance de mesure (16, 18).

2. Élément résistif selon l'une quelconque des revendications précédentes, **caractérisé en ce que** le premier bord (28a) et le deuxième bord (30a) de la première résistance de mesure (16) et/ou le premier bord (28b) et le deuxième bord (30b) de la deuxième résistance de mesure (18) s'étendent parallèlement entre eux.

3. Élément résistif selon l'une quelconque des revendications précédentes, **caractérisé en ce que** les bords libres de la première résistance de mesure (16), qui relient le premier bord (28a) et le deuxième bord (30a) de la première résistance de mesure (16), et/ou les bords libres de la deuxième résistance de mesure (18), qui relient le premier bord (28b) et le deuxième bord (30a) de la deuxième résistance de mesure (18), s'étendent parallèlement entre eux.

4. Élément résistif selon l'une quelconque des revendications précédentes, **caractérisé en ce que** les premiers bords (28a, 28b) et/ou les deuxièmes bords (30a, 30b) sont configurés de longueurs différentes.

5. Élément résistif selon l'une quelconque des revendications 1 à 3, **caractérisé en ce que** les premiers bords (28a, 28b) et/ou les deuxièmes bords (30a, 30b) sont configurés de même longueur.

6. Élément résistif selon l'une quelconque des revendications précédentes, **caractérisé en ce que** la direction longitudinale du premier élément de raccordement (12) et/ou la direction longitudinale du deuxième élément de raccordement (14) forme un angle inférieur à 90°, notamment de 0°, avec le premier bord (28a, 28b) de la résistance de mesure (16, 18) respectivement reliée.

7. Élément résistif selon l'une quelconque des revendications précédentes, **caractérisé en ce que** l'élément intermédiaire (20) s'étend essentiellement dans la direction des deuxièmes bords (30a, 30b).

8. Élément résistif selon l'une quelconque des revendications précédentes, **caractérisé en ce qu'**un troisième contact de mesure (26) est prévu sur l'élément intermédiaire (20), qui est agencé géométriquement entre la première résistance de mesure (16) et la deuxième résistance de mesure (18).

9. Procédé de fabrication d'un élément résistif (10) pour un capteur de batterie, notamment un capteur de batterie dans un véhicule, selon l'une quelconque des revendications précédentes, avec les étapes suivantes :
- la fourniture d'un matériau de base plat (40) constitué d'une première section (42), d'une deuxième section (44) et d'une section de résistance allongée (46), la première section (42) et la deuxième section (44) étant constituées d'un matériau électriquement conducteur, la section de résistance allongée (46) présentant deux bords opposés (48, 50), la première section (42) et la deuxième section (44) étant respectivement reliées de manière électriquement conductrice à l'un des bords (48, 50) de la section de résistance (46),
- la découpe de l'élément de résistance (10) dans le matériau de base (40), le premier élément de raccordement (12) et le deuxième élément de raccordement (14) étant découpés dans la première section (42), la première résistance de mesure (16) et la deuxième résistance de mesure (18) étant découpées dans la section de résistance (46) et l'élément intermédiaire (20) étant découpé dans la deuxième section (44),
- sur le premier élément de raccordement (12) et sur le deuxième élément de raccordement (14), la prévision de premiers contacts de mesure (22a, 22b), les contacts de mesure (22a, 22b) étant respectivement prévus sur une section de l'élément de raccordement (12, 14) tournée vers l'autre élément de raccordement respectif (12, 14), et
- sur l'élément intermédiaire (20), la prévision respectivement d'un deuxième contact de mesure (24a, 24b) associé à une résistance de mesure (16, 18), les deuxièmes contacts de mesure (30a, 30b) étant agencés respectivement dans une section de l'élément intermédiaire (20) détournée de l'autre résistance de mesure (16, 18).
